(19) Europäisches Patentamt
European Patent Office
Office européen des brevets

(11) Publication number: **0 036 221**
**B1**

(12) # EUROPEAN PATENT SPECIFICATION

(45) Date of publication of patent specification: **14.03.84**

(51) Int. Cl.³: **G 03 F 7/26**

(21) Application number: **81200063.6**

(22) Date of filing: **20.01.81**

(54) **Photosensitive material and a process for reproducing photo-information.**

(30) Priority: **20.02.80 GB 8005649**

(43) Date of publication of application:
**23.09.81 Bulletin 81/38**

(45) Publication of the grant of the patent:
**14.03.84 Bulletin 84/11**

(84) Designated Contracting States:
**BE DE FR GB**

(56) References cited:
**DE - A - 2 623 925**
**FR - A - 2 122 578**
**FR - A - 2 345 746**
**GB - A - 1 291 960**
**GB - A - 1 543 981**

(73) Proprietor: **AGFA-GEVAERT naamloze vennootschap**
**Septestraat 27**
**B-2510 Mortsel (BE)**

(72) Inventor: **Laridon, Urbain Leopold**
**Damhertenlaan 36**
**B-2610 Wilrijk (BE)**
Inventor: **Meisters, Augustijn Maria**
**Kasteelstraat 26**
**B-9219 Gent (BE)**
Inventor: **Priem, Jan Jozef**
**Kapellelei 27**
**B-2510 Mortsel (BE)**

**EP 0 036 221 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Photosensitive material and a process for reproducing photo-information

The present invention relates to a photosensitive material and a process for the reproducing of photo-information. More particularly the present invention relates to reprographic materials comprising a photosensitive layer suitable for producing a photoresist on a wash-off removable non-photosensitive coloured layer.

Basically, a photo-resist system is one in which a photosensitive layer applied on a support or base is information-wise exposed e.g. through a master image or pattern so that a change in solubility of that layer takes place and the more soluble parts can be removed selectively with a proper solvent. The photosensitive layer for forming the photoresist image can be coloured to form visible indicia but such at the expense of the photosensitivity.

According to the United Kingdom Patent Specification 1,291,960 there is produced a light-sensitive material comprising a translucent base, carrying thereon pigment, a light-sensitive substance and a pressure sensitive adhesive.

More particularly in example 2 of said specification a translucent film base was first coated with a coloured coating containing gelatin, methylene blue and microcapsules of adhesive. Thereon a light-sensitive coating was applied containing benzoquinone - (1:2) - diazide - (2) - 4 - (N:N - diphenyl)sulphonamide and alkali-soluble-phenolformaldehyde novolak resin. After exposure to light under a positive master the exposed portions of the two coatings were removed by washing with a 3% by weight aqueous solution of sodium phosphate.

Convenient imaging systems coatings for forming wash-off patterns should have the property of automatic wash-off processability in wash-off machines. Such brings about that where materials with separate photosensitive coatings and coloured coatings are used these coatings in the photo-exposed or non-photo exposed area, according to the type of resist used, should be capable of being removed with the same solvent and at comparable speed for both coatings.

It has been determined experimentally that coloured gelatin coatings are not sufficiently rapidly removable in moderately alkaline aqueous processing liquids at room temperature (20°C) and therefore a search was made for a more appropriate substitute.

According to the United Kingdom Patent Specification 1,385,241 a composite photosensitive element suited for the production of graphic art masks is provided which element comprises:

(a) a photosensitive layer comprising either (i) a photohardenable material which hardens upon exposure to actinic radiation or (ii) a crosslinkable photosensitive composition which undergoes decomposition upon exposure to actinic radiation to leave material in the unexposed areas which crosslinks and hardens upon treatment with a basic crosslinking agent; and in intimate surface contact therewith.

(b) a layer of a solvent-soluble, macromolecular organic polymer layer which layer (b) contains at least one dye or pigment and is essentially opaque to ultraviolet radiation and essentially transparent to visible actinic radiation. In practice said layer (b) contains known ultra-violet radiation-absorbing agents such as 2,3-dihydroxybenzophenone and 2,2' - dihydroxy - 4 - methoxybenzophenone but also yellow or orange dyes. By the term "solvent soluble" is meant in said last mentioned United Kingdom Patent Specification that the polymer of layer (b) should be soluble in a solvent used to develop the element (a) which has been exposed imagewise by dissolving and removing unhardened material in the unexposed or exposed areas of layer (a) while not dissolving hardened material in the remaining area of layer (a).

In the Examples of the last mentioned United Kingdom Patent Specification either organic solvents are used or mixtures of organic solvents with water for developing the composite photosensitive elements. As useful polymeric binders for the ultraviolet radiation absorbing layer are described e.g. a copolymer made from 90 mole% of methyl methacrylate and 10 mole% of methacrylic acid and a 15% acrylic hydrosol in water which is a termpolymer made from 55% of methyl methacrylate, 40% of ethyl acrylate and 5% of acrylic acid.

If possible the use of expensive and inflammable solvents that are polluting the waste water should be avoided.

Therefore in accordance with the present invention photosensitive recording materials are provided that are developable with alkaline aqueous liquids free from organic solvents.

More particularly in accordance with the present invention a photosensitive recording material is provided which comprises on a support:

(1) a photosensitive recording layer capable of obtaining in the photo-exposed area a selective increase or decrease of solubility in an alkaline aqueous liquid so that it can yield a negative or positive resist pattern by wash-off treatment with an aqueous alkaline liquid,

(2) subjacent to said photosensitive layer and in water-permeable relationship therewith a dyed and/or pigmented alkali-soluble non-photosensitive binder layer, characterised in that said non-photosensitive layer comprises in a proportion of at least 50% by weight with respect to the dye(s) and/or pigment(s) a non-gelatinaceous binder being a binding agent or mixture of binding agents containing free carboxylic acid groups in such a degree that it has a total acid

number between 90 and 350, the non-photosensitive binder layer being not soluble in pure water at 20°C but soluble in a 0.5% by weight aqueous sodium hydroxide solution at 20°C.

By "total acid number" is understood the quantity of base, expressed in milligrams of potassium hydroxide, that is required to neutralize all acidic constituents in 1 g of sample (ref. ASTM D 664—58). The binding agent or mixture of binding agents has a total acid number in the range of 90 to 300.

In the photoresist field two types of compositions are considered. The negative-acting photoresist compositions that are rendered insoluble in the exposed areas and the positive-acting photoresist compositions that become more soluble in the exposed parts. A survey of both types of photoresist materials is given by W. S. De Forest in his book "Photoresist materials and processes", McGraw-Hill Book Company (1975). Particulars about photosensitive compounds improving the solubility of a recording layer are described under the heading "Diazo Relief Images" by Kurt I. Jacobson — Ralph E. Jacobson in their book Imaging Systems — The Focal Press London and New York (1976) 173—179.

A recent survey of photoactive catalysts used in light induced photocuring of coating systems is given by Vincent D. McGinniss in Phot. Sc. & Eng. Vol. 23, no. 3, May/June (1979) 124—136.

In the production of positive photoresists suitable for use according to the present invention photosensitive compounds are used which improve on photoexposure the alkali-solubility of the photosensitive layer. Photosensitive o-quinone-diazides are preferred for that purpose.

In the photolysis of o-quinone diazides nitrogen is eliminated and a reactive ketocarbene radical is formed. The ketocarbene radical undergoes a Wolff-type rearrangement and gives a ketene derivative which on reacting with water forms an indene carboxylic acid which enhances the solubility in alkaline aqueous medium of the recording layer [see Unconventional Imaging Processes by Eric Brinckman et al., The Focal Press London and New York (1978), 65—67].

Particularly useful are the naphthoquinone-(1,2)-diazides (2) the preparation of which is described e.g. in Beilstein, "Handbuch der organischen Chemie" 4th Ed., vol. 16 (1933), page 533.

For application in the present invention said naphthoquinone-(1,2)-diazides (2) may be substituted e.g. with halogen, an aryl group including a substituted aryl group, a chlorosulphonyl group, a fluorosulphonyl group, an ester group e.g. an aryl carboxylate group or an aryl sulphonate group including said groups in substituted form, a sulphonamide group or a N-arylsulphonamide group.

Representatives of particularly useful substituted naphthoquinone - (1,2) - diazide - (2) compounds correspond, e.g. to one of the following general formulae (I) and (II):

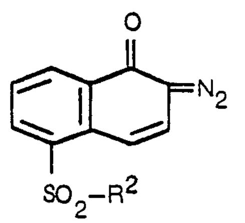

(I)

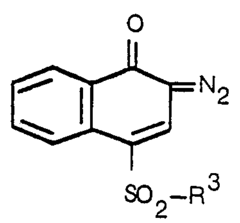

(II)

wherein:

$R^2$ represents fluorine, chlorine, an aryl group including a substituted aryl group, an aryloxy group including a substituted aryloxy group or an arylamino group including a substituted arylamino group, and

$R^3$ represents fluorine or an aryloxy group including a substituted aryloxy group.

Compounds according to at least one of said general formulae are described in the United States Patent Specifications 3,046,120—3,046,121—3,666,473, the United Kingdom Specifications 941,837—937,121—1,350,773—1,127,996 and 1,116,674 and the published German Patent Applications (DT—OS) 2,457,895—2,208,699 and 1,124,817.

Most preferred for use according to the present invention are the naphthoquinone - (1,2) - diazide - (2) compounds of general formula (I) wherein $R^2$ is an aryloxy group.

These compounds are prepared by well-known methods of chemical synthesis, e.g. by making to react the corresponding sulphonic acid chloride of 2 - diazonaphthol - (1) with the elected aromatic hydroxy-compound as described e.g. in the United States Patent Specification 3,046,121.

Generally speaking the bigger the molecules of the aromatic hydroxy-compounds condensed with the diazo-naphthol sulphonic acid chloride are, the better the phototransformation proceeds.

The naphthoquinone-(1,2)-diazide-(2)-5-sulphonic acid ester of 2,3,4-trihydroxybenzophenone described in the published German Patent Application 2,410,880 is particularly useful for the purpose of the present invention. Said diazide compound has the following structural formula (A):

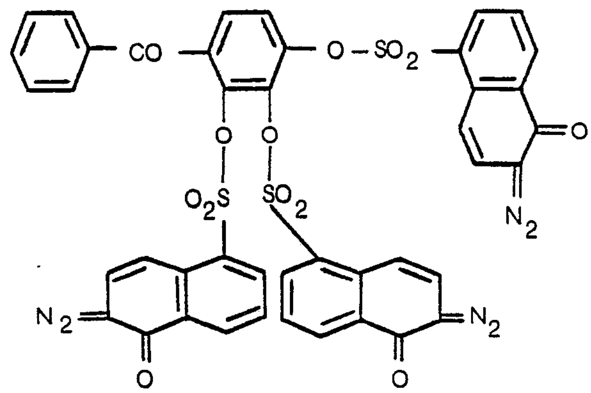

Sensitivity maxima at wavelength ($\lambda$): $\lambda_1$: 349 nm
$\lambda_2$: 401 nm
$\lambda_3$: 420 nm

Another particularly useful diazide compound is naphthoquinone(1, 2) - diazide - (2) - 5 - sulphonyl fluoride, which is described in the United Kingdom Patent Specification 1,116,674 and has the following structural formula (B):

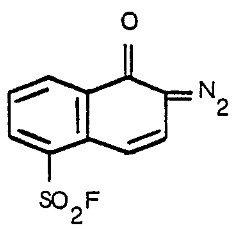

Sensitivity maxima at wavelength ($\lambda$): $\lambda_1$: 354 nm
$\lambda_2$: 397 nm
$\lambda_3$: 418 nm

Another group of photosensitive alkali-solubility improving compounds suitable for use in the present invention are diazosulphone compounds containing the group $-(SO_2-N=N)-$. The production of positive photoresists with such compounds is described in the United States Patent Specification 3,847,610. Preferred compounds are represented by one of the following general formulae:

$$X-SO_2-N=N-Y$$

and

$$X-SO_2-N=N-Z-N=N-SO_2-X^1$$

wherein:

X represents phenyl, naphthyl, or phenyl substituted in ortho, meta or para position with respect to the sulphonyl group by alkyl of 1 to 4 carbon atoms, carboxyl, amino, dialkylamino wherein the alkyl groups comprise 1 to 4 carbon atoms, acylamino wherein the acyl group comprises 2 to 7 carbon atoms, phenylazo or nitrophenylazo;

$X^1$ represents phenyl, aminophenyl or alkylphenyl wherein the alkyl group comprises 1 to 4 carbon atoms;

Y represents pyridyl, anthraquinonyl, naphthyl, acridinyl, benzothiazolyl or a group of the formula

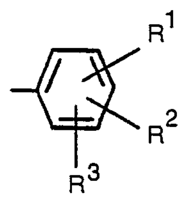

wherein

$R^1$ represents hydrogen, alkyl of 1 to 4 carbon atoms, nitro, alkoxy of 1 to 4 carbon atoms, carboxyl or sodium sulphonyl or NR'R'' wherein R' is hydrogen, alkyl of 1 to 4 carbon atoms, phenyl, acyl wherein the acyl group comprises 2 to 7 carbon atoms, p-methoxybenzoyl, p-nitrophenyl, naphthyl, acryloyl, methacryloyl or dialkylaminophenylcarbamoyl with alkyl groups of 1 to 4 carbon atoms; R'' is hydrogen, alkyl of 1 to 4 carbon atoms, or phenyl;

$R^2$ represents hydrogen, halogen, alkoxy with 1 or 2 carbon atoms, alkyl of 1 or 2 carbon atoms, or nitro;

$R^3$ represents hydrogen, halogen, alkoxy with 1 or 2 carbon atoms, or alkyl of 1 or 2 carbon atoms;

$R^1$, $R^2$ and $R^3$ are standing in ortho, meta or para position, and

Z represents a group of the formulae:

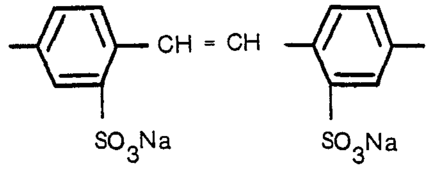

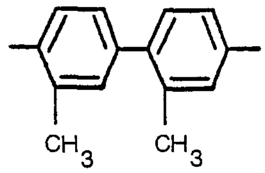

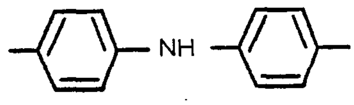

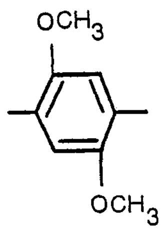

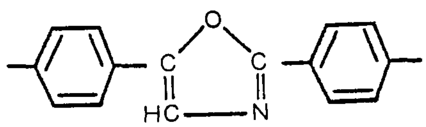

Examples of diazosulphone compounds within the scope of these formulae are listed here in Table 1.

TABLE 1

1) (phenylsulphonyl)-(p-tolyl)-diimide
2) (phenylsulphonyl)-(p-carboxyphenyl)-diimide
3) (phenylsulphonyl)-(p-nitrophenyl)-diimide
4) (phenylsulphonyl)-(p-methoxyphenyl)-diimide
5) (phenylsulphonyl)-(p-sulphophenyl)-diimide sodium salt
6) (p-tolylsulphonyl)-(4-pyridyl)-diimide
7) (p-tolylsulphonyl)-(9-acridinyl)-diimide
8) (p-tolylsulphonyl)-(2-benzothiazolyl)-diimide
9) (p-tolylsulphonyl)-(1-naphthyl)-diimide
10) (p-acetamidophenylsulphonyl)-(p-diethylaminophenyl)-diimide
11) (p-acetamidophenylsulphonyl)-(4-benzamido-2,5-diethoxyphenyl)-diimide
12) (p-dimethylaminophenylsulphonyl)-(p-nitrophenyl)-diimide
13) (p-dimethylaminophenylsulphonyl)-(p-diethylaminophenyl)-diimide
14) (1-naphthylsulphonyl)-(p-tolyl)-diimide
15) 3,3'-dimethyl-4,4-bis(p-aminophenylsulphonylazo)-biphenyl
16) 2,5-bis[4(p-tolylsulphonylazo)-phenyl]-oxazole
17) 4-(p-tolylsulphonylazo)-azobenzene
18) 1,4-dimethoxy-2(p-nitrophenylazo)-5(p-tolylsulphonylazo)-benzene
19) 4,4'-bis(p-tolylsulphonylazo)-diphenylamine
20) 4,4'-bis(phenylsulphonylazo)-2,2'-stilbene disulphonic acid disodium salt.

They are easily synthetised starting from diazonium salts and sulphinic acids.

An increase in the rate of photodissociation yielding an alkali-soluble compound starting from the diazosulphone compounds can be obtained by adding sensitizing dyes taken from the class of acridine, phenazine, thiazine and xanthene dyes, e.g. methylene blue, benzoflavine, thionine and erythrosine, in a concentration of 0.001 to 0.1% by weight based on the diazosulphone compound.

Examples of moderately alkali-soluble polymers suited for use according to the present invention in admixture with the above photoradical producing compounds increasing the alkali-solubility of the photosensitive layer after photo-exposure, belong to the class of copolymers of an unsaturated carboxylic acid, such as acrylic acid, methacrylic acid, crotonic acid, maleic acid, fumaric acid, itaconic acid, and citraconic acid. If the copolymer comprises an unsaturated dicarboxylic acid, the half-esters and half-amides thereof may be used too. These unsaturated carboxylic acids are copolymerised with ethylenically unsaturated compounds, which are substantially insoluble in alkaline medium and which are present in the copolymer in such a proportion that the copolymer itself remains moderately soluble in alkaline medium. Ethylenically unsaturated compounds that can be used for the copolymerisation are styrene and the derivatives thereof, vinyl chloride, vinylidene chloride, vinyl esters such as vinyl acetate, acrylates, methacrylates, acrylonitrile, methacrylonitrile e.g. copoly(ethylene/maleic acid) and copoly(methacrylic acid/methyl methacrylate).

Particularly suitable polymers for use in admixture with said naphthoquinone(1,2)-diazide (2) compounds are condensates of formaldehyde with phenol, which condensates are known as "novolaks".

According to Fred W. Billmeyer in the "Textbook of Polymer Chemistry" Interscience Publishers, Inc. New York (1967) p. 350 novolaks are produced in acid solution by reaction of a high ratio of phenol to formaldehyde yielding a linear, soluble, fusible polymer having the structure:

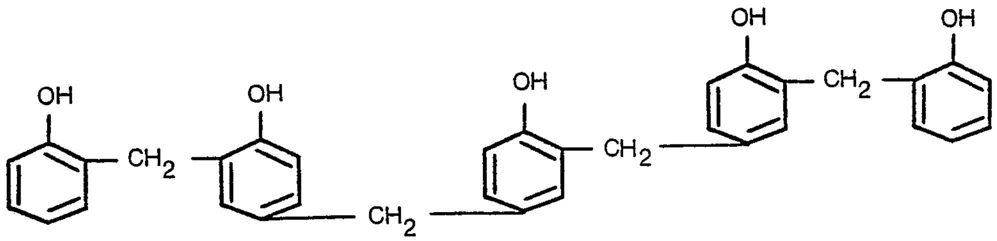

etc.

where ortho and para links occur at random. Molecular weights may range as high as 1000, corresponding to about ten phenyl groups. These materials do not themselves react further to give crosslinked resins. Further information about the preparation of novolaks can be found in C. Ellis "The Chemistry of Synthetic Resins" Volume 1 (1935), Reinbold Publishing Corp., New York, p. 303—309.

Good results are further obtained with condensates of formaldehyde with phenol or m-cresol, reacted with chloroacetic acid.

Likewise suited is a cellulose acetate phthalate having a degree of acetyl substitution (D.S. acetyl) between 1.0 and 1.7 and a degree of phthalyl substitution (D.S. phthalyl) between 0.6 and 1.2.

The proportions of alkali-soluble polymer(s) and of photosensitive o-quinone diazide compound(s) are preferably comprised between 1:1 and 7:1 by weight.

In the production of negative photoresists suitable for use according to the present invention photosensitive compounds are used which reduce on photoexposure the alkali-solubility of the photosensitive layer. For that purpose a large variety of photoradical forming compounds can be used which induce polymerization or cross-linking of ethylenically unsaturated compounds that initially were alkali-soluble.

A non-limitative survey of photoradical forming compounds also called photoinitiators is given by Kurt I. Jacobson & Ralph E. Jacobson in the book "Imaging Systems" — The Focal Press London and New York (1976) pages 181—198.

Particularly useful photoinitiators for use according to the present invention in the production of a negative photoresist are described in the United States Patent 3,501,296 and 3,558,309.

Preferred are the O-acylated oximinoketones also called oxime-ester photopolymerisation initiators the photolysis of which is presented in the Encyclopedia of Polymer Science and Technology, Supplement Vol. 1 (1976) John Wiley & Sons, Inc. p., 435.

These oxime-esters contain at least one oxime ester group of the following structure:

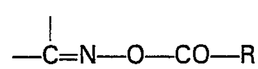

wherein R is an organic group.

Specific oxime esters which can be used as photopolymerisation initiator are within the scope of the following general formulae:

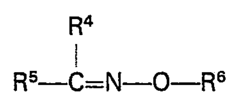

and

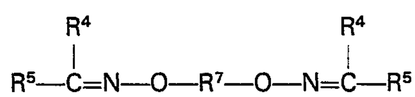

wherein:

$R^4$ represents an alkyl group comprising 1 or 2 carbon atoms, an aryl group, an alkaryl group, an aralkyl group, a hydroxy-substituted aralkyl group, or an acyl group including a substituted acyl group,

$R^5$ represents a hydrogen atom, an alkyl group comprising 1 or 2 carbon atoms, an aryl group, or an acyl group including a substituted acyl group, or wherein $R^4$ and $R^5$ together represent the necessary atoms to form with the adjacent carbon atom a cycloalkyl group, a phenanthrone group, or an indanone group,

$R^6$ represents an acyl group including a substituted acyl group, and
$R^7$ represents a diacyl group.

Preferably at least one of $R^4$ and $R^5$ is an acyl group including a substituted acyl group. The acyl groups for $R^4$, $R^5$ and $R^6$ are preferably acyl groups derived from aliphatic or aromatic carboxylic or sulphonic acids e.g. benzoyl, phenylsulphonyl, naphthoyl, anthraquinonyl-carbonyl, acetyl, propionyl, phenylacetyl, cinnamoyl, alkoxycarbonyl e.g. ethoxycarbonyl and N-substituted carbamoyl e.g. N-phenylcarbamoyl.

Particularly useful are the following oxime-esters of Table 2.

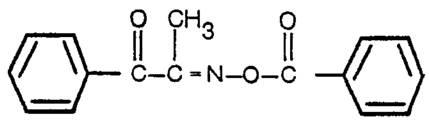

(A)

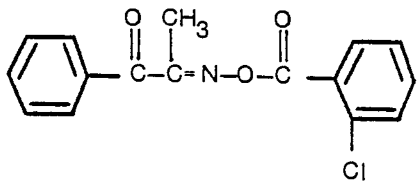

(B)

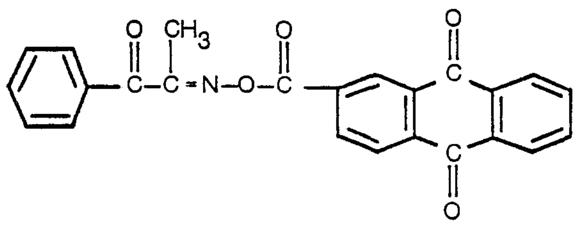

(C)

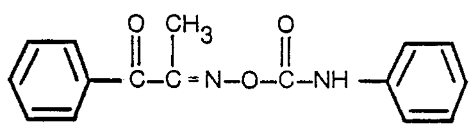

(D)

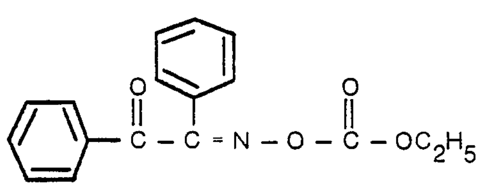

(E)

The photosensitivity of the oxime-ester photoinitiator compounds can be activated by suitable sensitizers as described e.g. in the European Patent Applications 79200429.3 and 80200033.1. Particularly suitable sensitizers are Michler's ketone and carbostyril compounds e.g. the following:

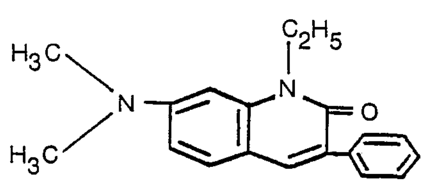

A photosensitive recording layer for the production of a negative photoresist suitable for use according to the present invention preferably comprises the photoinitiator in admixture with at least one polymerizable unsaturated carbon compound and an alkali-soluble binding agent. Preferred polymerizable unsaturated compounds have more than one carbon-to-carbon double bond, e.g. two terminal vinyl groups or are polymeric compounds having ethylenic unsaturation.

During photopolymerisation cross-linking will usually occur by means of the plurally unsaturated compound. Examples of such polymeric compounds containing ethylenically unsaturation are, e.g., allyl esters of polyacrylic acid, maleic esters of polyvinyl alcohol, polyhydrocarbons still containing carbon-to-carbon double bonds, unsaturated polyesters, cellulose acetomaleates, and allylcellulose.

Preferred photosensitive layers for negative resist formation comprise as plurally unsaturated photopolymerisable compounds the following:

divinylbenzene,
diglycol diacrylates,
N,N'-alkylene bis-acrylamides,
triethyleneglycol diacrylate,
triethyleneglycol dimethacrylate,
pentaerythritol triacrylate,
pentaerythritol tetraacrylate,
trimethylolpropane trimethacrylate,
bisphenol A-diacrylate.

Suitable alkali-soluble binding agents for the negative-resist forming layer are polymers and copolymers containing sufficient units of unsaturated monocarboxylic acids, e.g. acrylic acid, methacrylic acid, and crotonic acid, unsaturated dicarboxylic acids e.g. maleic acid, fumaric acid, itaconic acid, and citraconic acid as well as half-esters and half-amides of these dicarboxylic acids. These unsaturated carboxylic acids are copolymerised with ethylenically unsaturated compounds, which are substantially insoluble in alkaline medium and which are present in the copolymer in such a proportion that the copolymer itself remains soluble in alkaline medium. Ethylenically unsaturated compounds that can be used for the copolymerisation are styrene and derivatives thereof, vinyl chloride, vinylidene chloride, vinyl esters such as vinyl acetate, acrylates, methacrylates, acrylonitrile, methacrylonitrile e.g. copoly(ethylene/maleic acid) and copoly(methylmethacrylate/methacrylic acid).

Especially suitable are the alkali-soluble copolymers of methyl methacrylate and methacrylic acid wherein the ratio by weight between the monomeric units is between 90:10 and 75:25, more preferably between 85:15 and 80:20, and wherein the intrinsic viscosity of the copolymers measured in tetrahydrofuran at 20°C is between 0.05 and 0.20 dl/g, corresponding to molecular weights of about 7000 to 40,000.

These alkali-soluble copolymers of methylmethacrylate and methacrylic acid combine easy removability of the non-exposed portions with good mechanical strength i.e. resistance to abrasion of the exposed portions.

The proportions in the negative resist forming layer of binding agent and of photopolymerisable compound are preferably such that an exposure of said layer to actinic radiation of maximum 1 minute can effect at room temperature (20°C) a decrease in solubility of the exposed parts such that these parts do not dissolve in an aqueous solution (20°C) of 0.5 to 3% by weight of sodium hydroxide within 20 seconds. Weight ratios of alkali-soluble polymer to photopolymerisable compound between 1:2 and 5:1 are preferred.

Good results are obtained with 0.5—5% by weight of sensitizer and 2.5—10% by weight of oxime ester, preferably 1.5—5% by weight of sensitizer and 5—10% by weight of oxime ester, based on the total weight of alkali soluble binding agent and polymerisable compound.

Suitable photoinitiators for negative resist formation are further the nitrones described in the published German Patent Application 2,723,613 which has to be read in conjunction herewith. Suitable photosensitive compositions containing a mixture of nitrones and of naphthoquinone-(1,2)-diazide compounds for forming a negative or positive resist depending on the exposure intensity are described in the published German Patent Application 2,810,463.

The binding agent or mixture of binding agents of the dyed and/or pigmented non-photosensitive layer is selected preferably in such a way that it is not or only poorly (at most 10% by weight at 20°C) soluble in the solvent wherefrom the photosensitive layer is coated. Water-insoluble but alkali-soluble binding agents having free carboxylic acid groups are preferred e.g. prepared as a latex by addition polymerization of ethylenically unsaturated acids in combination with one or more other non-acidic ethylenically unsaturated compounds in order to bring the total acid number of the final polymer in the range of 60 to 350. Suitable water-insoluble but alkali-soluble binding agents are described in the United Kingdom Patent 1,338,900 and in the United States Patent 3,262,782. Particularly suitable binding agents are copolymers of an alkyl(meth)acrylate and (meth)acrylic acid wherein the (meth)acrylic acid content is preferably in the range of 20 to 50% by weight. The binder of the non-photosensitive layer may be applied from a solution in an organic solvent but is preferably applied from an aqueous dispersion (latex).

The substance providing a colour to the non-photosensitive layer may be a dye homogeneously dissolved in the binder of that layer or a pigment dispersed therein. When dyes are used they are preferably non-migratory. Preference is given to pigments, that are water and alkali-insoluble to prevent staining of the remaining resist parts.

Non-migratory dyes also known as organic pigment dyes are very useful particularly those sold under the trade marks "PIGMOSOL" and "COLANYL" which are trade marks of Badische Anilin- & Soda-Fabrik A.G. Ludwigshafen/Rh., W. Germany.

Examples thereof are HANSAYELLOW G30 COLANYL (C.I. 11,680); LITHOLSCHARLACH BSM

PIGMOSOL (trade mark) known also as PIGMENT RED 48 (C.I. 15,865) and HELIOGEN BLAU B COLANYL TEIG and PERMANENT GELB NCG COLANYL TEIG also known as Pigment Yellow 16 (C.I. 20,040). When a black colour is required preference is given to carbon black. To obtain a metallic luster dispersed metals e.g. colloidal aluminium particles can be used as pigments. In order to obtain fluorescent or phosphorescent panels e.g. useful in advertising the non-photosensitive coating may contain fluorescent or phosphorescent dyes or pigments to form visibly detectable indicia.

The dyes and/or pigments are mostly used with respect to the binding agent or binding agent mixture of the non-photosensitive layer in a weight ratio range of 1:10 to 1:1.

The support of the photosensitive recording material may be any type of solid plate sheet or belt material but is preferably a flexible resin material e.g. a cellulose nitrate film, cellulose acetate film, poly(vinylacetal) film polystyrene film, polyester film e.g. poly(ethylene terephthalate) film, polycarbonate film, a film made of poly-alpha-olefins such as a polyethylene or a polypropylene, and special purpose films such as a drawing film e.g. of the type described in the United States Patent Specifications 3,115,420 of John M. Centa, Albert L. Van Stappen and Louis F. Vogt Jr., issued December 24, 1963 and 3,627,563 of Raymond S. Richards, issued December 14, 1971. The support is usually 0.05 to 0.15 mm in thickness.

If the support is made of a transparent resin or glass reprographic transparencies can be made that may be used for making contact copies or projected, e.g. with an overhead projector. If the support is an opaque material e.g. baryta or alpha-olefin coated paper, opaque colour proofs can be made by washing off. If the support is made of metal, the resist with underlying coloured layer parts may be used as etch-resist the pattern of which can be easily visibly inspected before starting the etching.

It is also contemplated that the support may contain dyes or pigments e.g. white or fluorescent or phosphorescent dyes or pigments and the remaining pattern of the non-photosensitive layer acts as an opaque shield so that the uncovered i.e. the bared parts of the support form the indicia. When the support contains phosphorescent particles they have to be previously exposed to light. In the case where the base is fluorescent the uncovered parts forming the indicia would have to be activated with ultraviolet-radiation or X-rays.

Furthermore the support may have a composite structure e.g. includes (a) layer(s) that impart(s) to it a coloured or light-reflecting property e.g. includes a vacuum coated light-reflective metal layer e.g. aluminium layer or includes a binder coating containing partially embedded small spheres (about 100 $\mu$m diameter) of glass (glass beads) which will reflect ambient light in a rather small angle (about 15°) as is known from a glass beaded projection screen.

The support may at its rearside be provided with a pressure-sensitive adhesive layer covered with a peel off sheet or ribbon so that after processing the resulting material can be sticked to any other permanent support for lay-out mounting.

The photosensitive recording materials according to the present invention are prepared by coating the ingredients forming the photosensitive layer to the selected support already coated with the non-photosensitive dyed or pigmented layer by a known coating technique, e.g. by spin-coating, whirl-coating, spraying, dip-coating, roller-coating, air-knife coating, doctor-blade coating, etc.

The coating composition of the photosensitive layer as well as of the non-photosensitive layer may comprise besides the ingredients referred to hereinbefore matting agents e.g. silica particles in association with urea-formaldehyde resin, polymethylmethacrylate particles, etc., antistatic agents, coating aids, wetting agents, e.g. anionic and cationic surface active agents, silicon oils, etc.

For forming the coating composition of the photosensitive layer preferably a solution in (an) organic solvent(s) is (are) used. A low-boiling solvent, e.g. acetone, is preferred since after the coating step it can be easily removed by evaporation.

The thickness of the dried photosensitive recording layer and of the non-photosensitive dyed and/or pigmented layer may be in the range of 0.5 to 20 $\mu$m, and is preferably between 1 and 5 $\mu$m.

The process of the present invention for the reproducing of photo-information comprises the steps of (1) information-wise photo-exposing the photosensitive layer of the above described photosensitive material to selectively increase or reduce the alkali-solubility of said layer in the exposed area, (2) treating the photo-exposed layer with an aqueous alkaline liquid free from organic solvents to easy the removal of the more soluble parts of the photosensitive layer and also of the portions of the above described non-photosensitive layer, that are underlying the more soluble portions of the photosensitive layer and (3) smooth rubbing and rinsing with water to effect the wash-off of said parts and portions.

The alkalinity of the alkaline aqueous liquid is preferably not higher that is obtained in a 3% by weight aqueous sodium hydroxide solution at 20°C.

The processing of the photo-exposed recording materials of the present invention is advantageously carried out in an automatic processing apparatus, in which the material is transported automatically through processing stations in which the removal of the still soluble portions of the photosensitive layer and of the underlying dyed and/or pigmented non-photosensitive layer portions take place in successive stations.

For example in a particularly suitable processing apparatus for use in the production of reprographic images e.g. carbon black images produced according to the present invention, a first station comprises a tray for holding an appropriate alkaline aqueous liquid, through which the exposed recording

material is transported. After the alkaline development stage the surplus alkaline liquid absorbed in and adhering to the material is removed by passing the developed material through a second tray filled with plain water, whereupon the material is smoothly rubbed with a wet sponge roller rotating in a third tray filled with water (wash-off station) whereupon the processing is complete by carrying the material through a fourth tray containing plain water for rinsing the material. Processing preferably proceeds at room temperature (about 18 to about 25°C) but may proceed at higher temperatures. Care must be taken, however, not to damage the resist portions of the photosensitive layer.

The alkaline developing station and the wash-off station can be arranged separately but preferably they are grouped in a compact unit, in which the recording material is carried automatically at a constant speed from the alkaline developing tray into the other trays.

The total processing for the formation of the images in said trays normally lasts but about 30 seconds at 20—30°C. Taken with the speed of the photosensitive layer requiring exposure times in the order of a few seconds the present invention provides a rapid, highly reliable and convenient method for the formation of reprographic images.

The present invention makes it possible to produce dye or pigment images with very high contrast and excellent resolution at low cost. Mass production of line and half-tone images with high screen dot quality in a simple manner at high speed is made possible in a simple inexpensive equipment at low unit cost.

The synthesis of suitable alkali-soluble polymeric binding agents is exemplified in the following preparations:

Preparation 1

The following solution was formed:

| | |
|---|---|
| methyl methacrylate | 40 g |
| methacrylic acid | 10 g |
| 4,4′-azo-bis-4-cyanovaleric acid | 1.5 g |
| methanol | 500 ml |

This solution was refluxed for 24 hours under a nitrogen atmosphere while continuously stirring. After cooling the solution was poured into water. The white, powdery precipitate was isolated and was dried under vacuum.

Yield: 45 g of co(methyl methacrylate/methacrylic acid), having an intrinsic viscosity in tetrahydrofuran (20°C) of 0.155 dl/g. The copolymer comprised 18.4% by weight of methacrylic acid units. Total acid number: 120.

Preparation 2

A solution of 800 g of methyl methacrylate, 200 g of methacrylic acid and 30 g of 4,4′ - azo - bis - 4 - cyanovaleric acid in 10 l of acetone was refluxed for 24 hours while stirring under nitrogen atmosphere. After cooling a solution was obtained having a viscosity of 1.25 mPa.s at 20°C and having a copolymer concentration of 8% by weight. This solution can be used as such, without it being necessary to separate the copolymer. The separated copolymer had an intrinsic viscosity in tetrahydrofuran (20°C) of 0.173 dl/g and comprised 18.3% by weight of methacrylic acid units. Total acid number: 118.

Preparation 3

Copolymer of methacrylic acid, n-butyl acrylate, and methyl methacrylate.

A reaction vessel is equipped with an immersed spiral condenser, a stirrer, a liquid inlet tube connected with a dosing pump, and a double contact thermometer for regulating the temperature of the emulsion between 80 and 81°C.

A solution of 120 mg of carbon tetrabromide in a mixture of 420 g of methacrylic acid, 360 g of methyl methacrylate, and 420 g of n-butyl acrylate is added previously whilst stirring at room temperature in a separate vessel to a solution of 60 g of sodium dodecyl sulphate, 3.12 g of sodium hydrogen sulphite and 4 g of ammonium persulphate in 2250 ml of demineralised water. The resulting monomer emulsion is kept homogeneous by continuous stirring.

In the reaction vessel 880 mg of sodium hydrogen sulphite are dissolved in 1350 ml of demineralized water, whereupon 800 ml of the monomer emulsion are pumped rapidly at room temperature into the reaction vessel. The mixture is heated to 80°C whilst stirring. The polymerization is exothermic, so that the temperature must be kept beneath 81°C by means of the immersed spiral condenser.

After the exothermic phase, the remainder of the monomer emulsion is added within approximately 40 minutes. A solution of 400 mg of ammonium persulphate in 100 ml of demineralised water

is then added into the resulting latex and the reaction mixture is kept for 1 hour at 80°C whilst stirring.

After cooling to approximately 30°C and filtering through filter paper there is obtained 4.6 l of latex with 1190 g of copolymer consisting of 35% by weight of methacrylic acid, 35% by weight of n-butyl acrylate, and 30% by weight of methyl methacrylate.

This latex can be used as such or converted into powder by freeze-drying or the copolymer, free from soap, can be isolated as follows therefrom.

250 ml of 5N hydrochloric acid are then added to 2 l of latex. Subsequently, a small amount of acetone is added till complete coagulation of the copolymer. The residue is stirred in water, filtered, and finally washed with water till the filtrate reacts neutrally. After drying at 60°C there is obtained 520 g of copolymer. Total acid number: 228.

The invention is illustrated by the following examples without, however, limiting it thereto. All ratios and percentages are by weight unless otherwise indicated.

Example 1

— Preparation of the photosensitive reprographic material

The following coating dispersion of a non-photosensitive alkali-soluble layer was prepared by ball-milling for 16 h:

| | |
|---|---|
| co(ethyl acrylate/methyl methacrylate/ methacrylic acid) (17.5/52.5/30) having a total acid number of 195 | 2 g |
| carbon black RUSS PRINTEX 140 (trade name of Degussa — Frankfurt (M), W.-Germany) | 2 g |
| dispersing agent: mono-n-butyl phosphate/di-n-butyl phosphate (50/50) | 0.15 g |
| methanol | 10 ml |
| methyl ethyl ketone | 70 ml |
| ethylene glycol monomethyl ether | 5 ml |

The dispersion was coated at a coverage of 50 $\mu$m on a glass-bead coated light-reflecting resin support.

After 5 min drying at 80°C in a ventilated drying chamber a photosensitive positive photoresist layer was coated thereon from the following composition:

| | |
|---|---|
| ALNOVOL PN 430 (trade name of Reichold Albert Chemie, W.-Germany, for a novolak having a softening point of 126°C) | 2 g |
| naphthoquinone-(1,2)-diazide-(2) of structural formula (A) | 1 g |
| methyl ethyl ketone | 20 ml |
| n-butyl acetate | 20 ml |
| ethyl acetate | 60 ml |

The coating proceeded at a wet coverage of 50 $\mu$m and the drying at 80°C lasted 5 min.

Exposure and processing

The photosensitive coating of the above prepared reprographic material was exposed in contact through a positive line transparency. The exposure took 10 s with the exposure apparatus SPECTRAPROOF (trade name of Theimer GmbH, W.-Germany) containing a 2000 W mercury vapour lamp doped with gadolinium iodide and having emission maxima at 400 and 420 nm.

The processing of the exposed material was carried out in a 4-tray wash-off processor whose first tray contained 1 l of 1% aqueous sodium hydroxide solution, the second tray 1 l of water, the third tray a wet sponge roller and the fourth tray 1 l of water for rinsing.

The contact of each area of the material with the alkaline aqueous liquid proceeded at 20°C and lasted 20 s.

A contrasty black positive print was obtained on the light-reflecting support

Example 2

Example 1 was repeated with the difference, however, that as coating dispersion of the non-photosensitive layer the following was used:

| | |
|---|---|
| poly(vinyl hydrogen phthalate) (total acid number: 292) | 4 g |
| RUSS PRINTEX 140 (trade name) | 4 g |
| mono-n-butyl phosphate/di-n-butyl phosphate (50/50) | 0.15 g |
| acetone | 80 ml |
| ethylene glycol monomethyl ether | 5 ml |

The exposure and processing proceeded as in Example 1 with the difference, however, that the first tray of the wash-off processing apparatus was filled with a 3% aqueous potassium hydroxide solution wherein each area of the material was treated for only 5 s. A contrasty black positive print was obtained on the light-reflecting support.

Example 3

Example 1 was repeated with the difference, however, that as coating dispersion of the non-photosensitive layer the following was used:

cellulose acetate hydrogen phthalate having a degree of acetyl substitution (D.S. acetyl 1.6) and a degree of phthalyl substitution

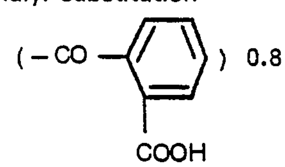

| | |
|---|---|
| (total acid number: 133) | 2 g |
| Pigment Red 48:1 (C.I. 15865:1) (also called LITHOLSCHARLACH 3700, trade name of BASF W.-Germany) | 2 g |
| mono-n-butyl phosphate/di-n-butyl phosphate (50/50) | 0.15 g |
| methanol | 10 ml |
| methyl ethyl ketone | 70 ml |
| ethylene glycol monomethyl ether | 5 ml |

The exposure and processing proceeded as in Example 1. A contrasty red positive print was obtained.

Example 4

Example 1 was repeated with the difference, however, that instead of the mentioned coating composition for forming the positive-resist-producing layer a negative-resist-forming layer was applied from the following coating composition:

| | |
|---|---|
| co(methyl methacrylate/methacrylic acid) (85/15) (total acid number: 98) | 4 g |
| pentaerythritol tetraacrylate | 2 g |
| oxime-ester compound (A) of Table 2 | 0.6 g |
| 1-ethyl-3-phenyl-7-dimethylamino-2-quinolinone | 0.3 g |

| | |
|---|---|
| methyl ethyl ketone | 35 ml |
| n-butyl acetate | 35 ml |
| ethyl acetate | 100 ml |

The exposure and processing were the same as in Example 1 with the difference, however, that the first tray of the wash-off processor contained an aqueous 1.5% sodium hydroxide solution.

A contrasty black negative print was obtained.

Example 5

Example 1 was repeated with the difference, however, that instead of the mentioned coating dispersion of the non-photosensitive layer the following was used:

8.8 g of colloidal carbon having a particle size of approximately 50 nm was dispersed in a mixture of 300 ml of ethanol and 16 ml of a 27.6% by weight latex of co(methacrylic acid/n-butyl acrylate/methyl methacrylate) (35:35:30% by weight). This copolymer was obtained according to preparation 3.

A solution in 300 ml of ethanol of 17.6 g of polymethylene-p-hydroxybenzoic acid (prepared as described in Preparation 8 of the United Kingdom Patent Specification 1,338,900, was added to the resulting dispersion of colloidal carbon whilst stirring. This solution was diluted afterwards with 370 ml of ethanol. The dispersion thus formed was applied to the surface of a biaxially oriented polyethylene terephthalate film having a thickness of 100 $\mu$m, at a ratio of 35 sq.m.

i) To the dried non-photosensitive pigmented layer the photosensitive layer of Example 1 was applied. The obtained material was exposed and processed as in Example 1 and a contrasty black positive line transparency was obtained.

ii) As an alternative to the dried non-photosensitive pigmented layer the photosensitive layer of Example 4 was applied. The obtained material was exposed and processed as in Example 4 and a contrasty black negative line transparency was obtained.

Example 6

Example 1 was repeated with the difference that the binder of the coating dispersion was replaced by a copolymer of methylmethacrylate-methacrylic acid (50/50) having a total acid number of 325.

The exposure and processing proceeded as in Example 1. A contrasty black positive print was obtained.

Example 7

Comparison material A

The following dispersion for coating a non-photosensitive alkali-soluble gelatin binder layer (out of the scope of the present invention) was prepared:

| | |
|---|---|
| water | 385 ml |
| 20% aqueous gelatin solution | 100 ml |
| 20% aqueous carbon black dispersion DERUSSOL C (trade name of Degussa, Frankfurt (M), W.-Germany) | 10 ml |
| 5% aqueous solution of $F_{17}C_8SO_3^-.N^+(C_2H_5)_4$ (wetting agent) | 5 ml |

The dispersion was coated onto the support of the reprographic material of Example 1. in such a way that 2 g of gelatin were present per sq.m. To the dried non-photosensitive pigment layer the photosensitive layer of Example 1 was applied.

Comparison material B

The following dispersion for coating a non-photosensitive pigmented alkali-soluble binder layer for use according to the present invention was prepared:

| | |
|---|---|
| 20% aqueous carbon black dispersion DERUSSOL C (trade name) | 10 ml |
| ethanol | 300 ml |

| | |
|---|---|
| 20% latex of co(ethyl acrylate/methyl methacrylate/methacrylic acid) (25/50/25) total acid number: 163 | 100 ml |
| aqueous ammonia solution | 90 ml |
| 5% aqueous solution of $F_{17}C_8SO_3^-.N^+(C_2H_5)_4$ (wetting agent) | 4 ml |

The dispersion was coated in such a way that 2 g of the copolymer were present per sq.m.

To the dried non-photosensitive pigmented layer the photosensitive layer of Example 1 was applied.

Processing

Comparison materials A and B were exposed and processed as described in Example 1. With material A no useful reprographic print could be obtained because the gelatin portions underlying the exposed photosensitive layer portions were not removed adequately. The comparison material B yielded a clean contrasty black positive print.

## Claims

1. Photosensitive recording material which comprises on a support:

(1) a photosensitive recording layer capable of obtaining in the photo-exposed area a selective increase or decrease of solubility in an alkaline aqueous liquid so that it can yield a negative or positive resist pattern by wash-off treatment with an aqueous alkaline liquid.

(2) subjacent to said photosensitive layer and in water permeable relationship therewith a dyed and/or pigmented alkali-soluble non-photosensitive binder layer, characterized in that said non-photosensitive layer comprises in a proportion of at least 50% by weight with respect to the dye(s) and/or pigment(s) a non-gelatinaceous binder being a binding agent or mixture of binding agents containing free carboxylic acid groups in such a degree that it has a total acid number between 90 and 350, the non-photosensitive binder layer being not soluble in pure water at 20°C but soluble in a 0.5% by weight aqueous sodium hydroxide solution at 20°C.

2. Photosensitive recording material according to claim 1, characterized in that the binding agent or mixture of binding agents of the dyed and/or pigmented non-photosensitive layer is selected in such a way that it is not or only at most 10% by weight at 20°C soluble in the solvent wherefrom the photosensitive layer is coated.

3. Photosensitive recording material according to claim 1 or 2, characterized in that, the binder of the non-photosensitive layer is applied from an aqueous dispersion and the photosensitive layer is applied from a solution containing organic solvent(s).

4. Photosensitive recording material according to any of claims 1 to 3, characterized in that, the binder of the non-photosensitive layer is a copolymer of an alkyl(meth)acrylate and (meth)acrylic acid wherein the (meth)acrylic acid content is in the range of 20 to 50% by weight.

5. Photosensitive recording material according to any of the claims 1 to 4, characterized in that, the non-photosensitive layer contains dispersed therein a non-migratory organic dye or carbon black.

6. Photosensitive recording material according to any of the claims 1 to 5, characterized in that the non-photosensitive layer has a thickness in the range of 0.5 to 20 $\mu$m.

7. Photosensitive recording material according to any of the claims 1 to 6, characterized in that, the support has a composite structure including a layer that imparts to it a light-reflecting property.

8. Photosensitive recording material according to claim 7, characterized in that said layer is a binder-coating containing partially embedded glass beads.

9. Photosensitive recording material according to any of claims 1 to 8, characterized in that the support at its rear-side is provided with a pressure sensitive adhesive layer covered with a peel-off sheet or ribbon.

10. Process for the reproducing of information comprising the steps of (1) information-wise photo-exposing the photosensitive layer of the recording material of any of the claims 1 to 9, to selectively increase or reduce the alkali-solubility thereof in the exposed area, (2) treating the photo-exposed layer with an aqueous alkaline liquid free from organic solvents to easy the removal of the more soluble parts of the photosensitive layer and also of the portions of the non-photosensitive layer of said recording material that are underlying the more soluble portions of the photosensitive layer and (3) smooth rubbing and rinsing with water to effect the wash-off of said parts and portions.

11. Process according to claim 10, wherein the aqueous alkaline liquid has an alkalinity not higher than obtained with a 3% by weight aqueous sodium hydroxide solution at 20°C.

**Revendications**

1. Matériau d'enregistrement photosensible comprenant, sur un support:

(1) une couche d'enregistrement photosensible pouvant subir, dans les zones exposées à la lumière, une augmentation ou une réduction sélective de solubilité dans un liquide aqueux alcalin de telle sorte qu'elle puisse former une image de réserve négative ou positive par un traitement d'élimination par lavage avec un liquide alcalin aqueux,
(2) en dessous de cette couche photosensible et dans une relation de perméabilité à l'eau avec cette dernière, une couche de liant non photosensible, soluble dans les alcalis, colorée et/ou pigmentée, caractérisé en ce que cette couche non photosensible comprend, dans une proportion d'au moins 50% en poids vis-à-vis du ou des colorants et/ou du ou des pigments, un liant non gélatineux qui est un agent liant ou un mélange d'agents liants contenant des groupes d'acides carboxyliques libres à un degré tel que cet agent liant ou ce mélange ait un indice d'acide total compris entre 90 et 350, la couche de liant non photosensible n'étant pas soluble dans l'eau pure à 20°C, mais soluble dans une solution aqueuse à 0,5% en poids d'hydroxyde de sodium à 20°C.

2. Matériau d'enregistrement photosensible suivant la revendication 1, caractérisé en ce que l'agent liant ou le mélange d'agents liants de la couche non photosensible colorée et/ou pigmentée est choisi de telle sorte qu'il ne soit pas soluble ou qu'il ne soit tout au plus soluble qu'a raison de 10% en poids à 20°C dans le solvant à partir duquel la couche photosensible est coulée.

3. Matériau d'enregistrement photosensible suivant la revendication 1 ou 2, caractérisé en ce que le liant de la couche non photosensible est appliqué à partir d'une dispersion aqueuse, tandis que la couche photosensible est appliquée à partir d'une solution contenant un ou plusieurs solvants organiques.

4. Matériau d'enregistrement photosensible suivant l'une quelconque des revendications 1 à 3, caractérisé en ce que le liant de la couche non photosensible est un copolymère d'un (méth)acrylate d'alkyle et d'acide (méth)acrylique dans lequel la teneur en acide (méth)acrylique se situe dans l'intervalle allant de 20 à 50% en poids.

5. Matériau d'enregistrement photosensible suivant l'une quelconque des revendications 1 à 4, caractérisé en ce que la couche non photosensible contient, en dispersion, du noir de carbone ou un colorant organique ne migrant pas.

6. Matériau d'enregistrement photosensible suivant l'une quelconque des revendications 1 à 5, caractérisé en ce que la couche non photosensible a une épaisseur se situant dans l'intervalle allant de 0,5 à 20 $\mu$m.

7. Matériau d'enregistrement photosensible suivant l'une quelconque des revendications 1 à 6, caractérisé en ce que le support a une structure composite comportant une couche lui conférant une propriété de réflexion de la lumière.

8. Matériau d'enregistrement photosensible suivant la revendication 7, caractérisé en ce que cette couche est un revêtement d'un liant contenant des perles de verre partiellement enrobées.

9. Matériau d'enregistrement photosensible suivant l'une quelconque des revendications 1 à 8, caractérisé en ce que, sur sa face dorsale, le support comporte une couche d'un adhésif sensible à la pression recouverte d'une feuille ou d'un ruban à détacher.

10. Procédé pour la reproduction d'informations, caractérisé en ce qu'il comprend les étapes qui consistent à: (1) soumettre la couche photosensible du matériau d'enregistrement suivant l'une quelconque des revendications 1 à 9 à une exposition à la lumière sous forme d'informations afin d'en augmenter ou d'en réduire sélectivement la solubilité dans les alcalins dans les zones exposées, (2) traiter la couche exposée à la lumière avec un liquide alcalin aqueux exempt de solvants organiques afin d'éliminer aisément les parties plus solubles de la couche photosensible et également les portions de la couche non photosensible de ce matériau d'enregistrement qui se trouvent en dessous des portions plus solubles de la couche photosensible, et (3) frotter doucement et rincer avec de l'eau pour éliminer ces parties et portions.

11. Procédé suivant la revendication 10, caractérisé en ce que le liquide alcalin aqueux a une alcalinité de dépassant pas celle obtenue avec une solution aqueuse à 3% en poids d'hydroxyde de sodium à 20°C.

**Patentansprüche**

1. Photoempfindliches Aufzeichnungsmaterial, das auf einem Träger enthält:

(1) eine photoempfindliche Aufzeichnungsschicht, die an den photobelichteten Stellen eine selektive Zunahme oder Abnahme der Löslichkeit in einer alkalischen, wäßrigen Flüssigkeit zu erhalten vermag, so daß sie durch Wegwaschen (Wash-Off-Behandlung) in einer alkalischen, wäßrigen Flüssigkeit ein negatives oder positives Ätzreservemuster erzeugen kann,

(2) unterhalb dieser photoempfindlichen Schicht und in wasserdurchlässiger Beziehung damit eine gefärbte und/oder pigmentierte, alkalilösliche, nicht-photoempfindliche Bindemittelschicht, dadurch gekennzeichnet, daß letztere in einem Gewichtsverhältnis von mindestens 50% in bezug auf den oder die Farbstoffe und/oder das oder die Pigmente eine nichtgelatineartiges Bindemittel enthält, das ein Bindemittel oder eine Mischung von Bindemitteln ist, das bzw. die eine solche Menge Carboxylgruppen enthält, daß es eine Gesamtsäurezahl zwischen 90 und 350 hat, wobei die nicht-photoempfindliche Bindemittelschicht unlöslich ist in reinem Wasser bei 20°C, aber löslich ist in einer 0,5 gew.-%igen wäßrigen Natriumhydroxidlösung bei 20°C.

2. Photoempfindliches Aufzeichnungsmaterial nach Anspruch 1, dadurch gekennzeichnet, daß das Bindemittel oder die Mischung von Bindemitteln der gefärbten und/oder pigmentierten nicht-photoempfindlichen Bindemittelschicht derart ausgewählt ist, daß es bzw. sie bei 20°C nicht oder zu höchstens 10 Gew.-% löslich ist im Lösungsmittel, aus dem die photoempfindliche Schicht aufgetragen wurde.

3. Photoempfindliches Aufzeichnungsmaterial nach Anspruch 1 oder 2, dadurch gekennzeichnet, daß das Bindemittel der nicht-photoempfindlichen Schicht aus einer wäßrigen Dispersion und die photoempfindliche Schicht aus einer, eine oder mehrere organische Lösungsmittel enthaltenden Lösung aufgetragen wurde.

4. Photoempfindliches Aufzeichnungsmaterial nach irgendeinem der Ansprüche 1—3, dadurch gekennzeichnet, daß das Bindemittel der nicht-photoempfindlichen Schicht ein Copolymeres aus einem Alkyl(meth)acrylat und (Meth)acrylsäure ist, wobei der (Meth)acrylsäuregehalt 20—50 Gew.-% beträgt.

5. Photoempfindliches Aufzeichnungsmaterial nach irgendeinem der Ansprüche 1—4, dadurch gekennzeichnet, daß die nicht-photoempfindliche Schicht, darin dispergiert, einen diffusionsfesten organischen Farbstoff oder Ruß enthält.

6. Photoempfindliches Aufzeichnungsmaterial nach irgendeinem der Ansprüche 1—5, dadurch gekennzeichnet, daß die nicht-photoempfindliche Schicht 0,5—20 $\mu$m dick ist.

7. Photoempfindliches Aufzeichnungsmaterial nach irgendeinem der Ansprüche 1—6, dadurch gekennzeichnet, daß der Träger einen Verbundaufbau einschließlich einer Schicht hat, die ihm eine lichtreflektierende Eigenschaft verleiht.

8. Photoempfindliches Aufzeichnungsmaterial nach Anspruch 7, dadurch gekennzeichnet, daß diese Schicht eine Bindemittelschicht ist, die teilweise eingebettete Glasperlchen enthält.

9. Photoempfindliches Aufzeichnungsmaterial nach irgendeinem der Ansprüche 1—8, dadurch gekennzeichnet, daß der Träger an dessen Rückseite versehen ist mit einer druckempfindlichen Haftschicht, die mit einer abziehbaren Folie oder einem abziehbaren Band versehen ist.

10. Verfahren zum Reproduzieren von Information, das die folgenden Stufen umfaßt: (1) informationsmäßige Photobelichtung der photoempfindlichen Schicht des Aufzeichnungsmaterials nach irgendeinem der Ansprüche 1—9, um dessen Alkalilöslichkeit an den belichteten Stellen selektiv zu steigern oder zu vermindern, (2) Behandlung der photobelichteten Schicht mit einer wäßrigen alkalischen Flüssigkeit, die frei ist von organischen Lösungsmitteln, um die Entfernung der löslicheren Teile der photoempfindlichen Schicht, sowie der Bereiche der nicht-photoempfindlichen Schicht des Aufzeichnungsmaterials, die unter den löslicheren Teilen der photoempfindlichen Schicht leigen, zu erleichtern, und (3) sanftes Reiben und Spülen mit Wasser, um dies Teile und Bereiche wegzuwaschen.

11. Verfahren nach Anspruch 10, dadurch gekennzeichnet, daß die wäßrige alkalische Flüssigkeit eine Alkalinität hat, die die mit einer 3 gew.-%igen wäßrigen Natriumhydroxidlösung erzielte nicht übersteigt.